# EUROPÄISCHE PATENTANMELDUNG

(11) **EP 1 411 450 A2**
(43) Veröffentlichungstag der Anmeldung: **21.04.2004**
(21) Anmeldenummer: 03103550.4
(22) Anmeldetag: 25.09.2003
(51) Int. Cl.: G06F 17/50

(54) **Verfahren, Anordnung und Computerprogramm zur Ermittlung einer Graphenstruktur zur Beschreibung einer Fläche mit einer Freifläche und Hindernissen**

(30) Priorität: 14.10.2002 DE 10247772
(71) Anmelder: SIEMENS AKTIENGESELLSCHAFT, 80333 München (DE)
(72) Erfinder: Bade, Richard, 39624, Messdorf (DE); de Graeve, Charles-Marie, 76131, Karlsruhe (DE); Fiegert, Michael, 81739, München (DE)

(57) **Zusammenfassung**

Verfahren und Anordnung sowie Computerprogramm mit Programmcode-Mitteln und Computerprogramm-Produkt zur Ermittlung einer Graphenstruktur zur Beschreibung einer Fläche mit einer Freifläche und Hindernissen

Die Erfindung betrifft eine Ermittlung einer Graphenstruktur zur Beschreibung einer Fläche mit einer Freifläche und Hindernissen. Dabei wird eine topologische Graphenstruktur für die Freifläche ermittelt. Die topologische Graphenstruktur wird mit Abstandsinformation angereichert und dabei die Graphenstruktur gebildet. Die Abstandsinformation ist derart ausgebildet, dass unter Verwendung der mit der Abstandsinformation angereicherten Graphenstruktur die Hindernisse der Fläche ermittelbar sind.

## Beschreibung

Die Erfindung betrifft eine Ermittlung einer Graphenstruktur zur Beschreibung einer Fläche mit einer Freifläche und Hindernissen.

Immer häufiger werden sich wiederholende Tätigkeiten Servicerobotern übertragen. Beispiele für solche Tätigkeiten sind Reinigungsaufgaben, Transportaufgaben, das Ausbringen von Saatgut auf entsprechende Flächen oder beispielsweise das Rasenmähen.

Zur Durchführung der jeweiligen Flächenbearbeitung sind an solchen Servicerobotern jeweils zugehörige Flächenbearbeitungsgeräte, wie eine Reinigungsvorrichtung oder eine Schneidvorrichtung, angebracht.

Eine effiziente Bearbeitung der Fläche durch den Serviceroboter setzt voraus, dass das Flächenbearbeitungsgerät möglichst die gesamte zu bearbeitende Fläche überstreicht, wobei möglichst wenig Wege doppelt gefahren werden.

Dazu ist allerdings eine Planung einer geeigneten, effizienten Bearbeitungsbahn von Nöten.

Bahnplanungsverfahren im allgemeinen setzen eine Kenntnis über die geometrischen Gegebenheiten der zu bearbeitenden Fläche voraus. Dazu zählen beispielsweise Informationen über Abmessungen der zu bearbeitenden Fläche und Lagen und Abmessungen darin vorhandener Hindernisse.

In der Regel werden digitale, geometrische Karten verwendet, in welchen die jeweiligen geometrischen Gegebenheiten einer zu bearbeitenden Fläche gespeichert sind.

Eine solche digitale, geometrische Karte kann bei entsprechendem Vorwissen vorab erstellt und in einem Serviceroboter gespeichert sein. In diesem Fall kann das Bahnplanungsverfahren bzw. die Bahnplanung vorab durchgeführt werden. Die abzufahrende Bahn ist bei Beginn der Flächenbearbeitung bekannt.

Auch kann eine digitale, geometrische Karte erst während einer Flächenbearbeitung dynamisch erstellt werden. In diesem Fall erfolgt die Bahnplanung während der Flächenbearbeitung.

Verschiedene Verfahren zur Erstellung solcher geometrischen Karten sind aus [11], [12], [13] bekannt.

Bahnplanungsverfahren basierend auf diesen geometrischen Karten sind ebenfalls bekannt. Beispielhaft werden nachfolgend verschiedene Bahnplanungsverfahren genannt.

Sogenannte template-basierte Verfahren zur flächendeckenden Bahnplanung, welche solche geometrischen digitalen Karten verwenden, sind beispielsweise aus [2], [3], [4] bekannt. Ein weiteres Bahnplanungsverfahren [5], welches ebenfalls eine geometrische digitale Karte verwendet, aber einen anderen Ansatz aufweist, verwendet ein Potentialfeld, mit welchem eine zu bearbeitende Fläche überlagert und daraus eine Bearbeitungsbahn bestimmt wird. Weitere Karten-basierte Bahnplanungsverfahren mit ähnlichem Ansatz basierend auf geometrischen Karten sind aus [6] und [7] bekannt.

Neben der Ermittlung einer Bearbeitungsbahn dienen solche geometrischen Karten auch als Grundlage zur Ermittlung einer aktuellen Position bzw. eines Aufenthaltsorts eines mobilen Roboters in einer Fläche (Positionsschätzung). Dieses wird als Lokalisierung oder globale Lokalisierung bezeichnet. Des weiteren dienen solche geometrischen Karten auch zur Orientierung und Navigation des Roboters in einer Fläche.

Entsprechende Verfahren zur Lokalisierung bzw. globalen Lokalisierung, Orientierung und Navigation von mobilen Robotern, basierend auf geometrischen Karten, sind auch bekannt, beispielsweise aus [8] .

Nachteilig an diesen geometrischen Karten ist, dass diese erheblichen Speicherplatz benötigen oder abhängig sind von einem Typ der Umgebung und bei Verwendung, beispielsweise zur Relokalisierung, hohe Rechenzeiten erfordern.

Desweiteren ist von Nachteil, dass die Erstellung solcher geometrischen Karten aufwendig ist und die Karten selbst meist ungenau sind, insbesondere in großen und/oder unstrukturierten Umgebungen.

Neben solchen geometrischen Karten sind auch topologische Karten zur Lokalisierung und Navigation von mobilen Robotern in einer Fläche bekannt.

Diese topologischen Karten verwenden zur Beschreibung einer Fläche einen Graphen bzw. eine Graphenstruktur, welcher bzw. welche in der Regel gebildet wird aus einer zusammenhängenden Abfolge von Knoten und Kanten.

Als derartige topologisch verwendete bzw. "topologische" Graphen oder Graphenstrukturen sind zum Beispiel bekannt sogenannte Voronoi-Graphen (VG) oder generalisierte Voronio-Graphen (GVG) [8], [9], [10] sowie sogenannte "medial axis" [1], [8].

Die "medial axis" (MA) werden dabei gebildet durch die Orte bzw. die Menge von Kreismittelpunkten aller maximal großer Kreise, die vollständig in einer abgeschlossenen Fläche liegen und mindestens zweimal tangieren.

Allerdings werden durch diese topologischen Graphen nur Freiflächen einer Fläche beschrieben, nicht aber explizit Hindernisse in der Fläche und nicht aber diese in einer solchen Form, welche eine Reproduktion der Hindernisse ermöglichen würde.

Die Beschreibung der Freiflächen durch die Graphen erfolgt dabei strukturell und nicht metrisch, d.h. genauere geometrische Informationen über die Fläche, wie Abstände oder Abmessungen zu Hindernissen, sind den Graphen in der Regel nicht entnehmbar.

Daher eignen sich solche "topologischen" Graphen, wie Voronoi-Graphen oder medial axis, nur eingeschränkt zur Lokalisierung bzw. globalen Lokalisierung, Orientierung oder Navigation eines mobilen Roboters.

Aus [1] ist ein sogenannter Shock-Graph (SG) bekannt, welcher dort bei einer Bildverarbeitung bzw. Objekterkennung zur strukturellen Beschreibung von durch Umrisslinien abgeschlossenen Flächen und Formen verwendet wird.

Der Erfindung liegt die Aufgabe zugrunde, eine Beschreibung einer Fläche mit Freiflächen und Hindernissen zur Verfügung zu stellen, die einfach zu ermitteln und darzustellen ist sowie geringen Speicherplatz bedarf. Darüber hinaus soll sie aber ausreichend Information beinhalten, um zur Lokalisierung bzw. Relokalisierung, Orientierung oder Navigation eines mobilen Roboters verwendbar zu sein.

Diese Aufgabe wird durch das Verfahren und die Anordnung sowie durch das Computerprogramm mit Programmcode-Mitteln und das Computerprogramm-Produkt zur Ermittlung einer Graphenstruktur zur Beschreibung einer Fläche mit einer Freifläche und Hindernissen mit den Merkmalen gemäß dem jeweiligen unabhängigen Patentanspruch gelöst.

Bei dem Verfahren zur Ermittlung einer Graphenstruktur zur Beschreibung einer Fläche mit einer Freifläche und Hindernissen
- wird eine topologische Graphenstruktur für die Freifläche der Fläche ermittelt,
- wird die topologische Graphenstruktur mit Abstandsinformation angereichert und dabei die Graphenstruktur gebildet.
Die Abstandsinformation ist derart ausgebildet, dass unter Verwendung der mit der Abstandsinformation angereicherten Graphenstruktur die Hindernisse der Fläche ermittelbar sind.

Bei der Anordnung zur Ermittlung einer Graphenstruktur zur Beschreibung einer Fläche mit einer Freifläche und Hindernissen
- ist eine topologische Graphenstruktur für die Freifläche der Fläche ermittelbar,
- ist die topologische Graphenstruktur mit Abstandsinformation anreicherbar und dabei die Graphenstruktur bildbar.
Die Abstandsinformation ist derart ausgebildet, dass unter Verwendung der mit der Abstandsinformation angereicherten Graphenstruktur die Hindernisse der Fläche ermittelbar sind.

Anschaulich gesehen werden bei der Erfindung im Gegensatz zu bekannten digitalen, geometrischen Karten, bei welchen jeweils die gesamte Fläche mit allen Hindernissen gespeichert wird, nur Form und Topologie einer Freifläche der Fläche in effizienter Form, in diesem Fall unter Verwendung eines topologisch verwendeten bzw. "topologischen" Graphen oder Graphenstruktur, wie zum Beispiel eines Shock-Graphen, einer "medial axis" oder eines Voronoi-Graphen, gespeichert.

Diese topologischen Graphen bzw. Graphenstrukturen werden weiter durch geeignete Abstandsinformation angereichert (annotiert), was beispielsweise zu sogenannten annotierten medial axis führt. Die Abstandsinformation enthält dabei solche Information, die es ermöglicht, zusammen mit der Graphenstruktur Hindernisse der Fläche zu reproduzieren.

In der Regel, nicht aber notwendigerweise, stimmen Hindernisse mit Teilabschnitten von Begrenzungen einer Freifläche überein.

Das Computerprogramm mit Programmcode-Mitteln ist eingerichtet, um alle Schritte gemäß des erfindungsgemäßen Verfahrens durchzuführen, wenn das Programm auf einem Computer ausgeführt wird.

Das Computerprogramm-Produkt mit auf einem maschinenlesbaren Träger gespeicherten Programmcode-Mitteln ist eingerichtet, um alle Schritte gemäß des erfindungsgemäßen Verfahrens durchzuführen, wenn das Programm auf einem Computer ausgeführt wird.

Die Anordnung sowie das Computerprogramm mit Programmcode-Mitteln, eingerichtet um alle Schritte gemäß dem erfinderischen Verfahren durchzuführen, wenn das Programm auf einem Computer ausgeführt wird, sowie das Computerprogramm-Produkt mit auf einem maschinenlesbaren Träger gespeicherten Programmcode-Mitteln, eingerichtet um alle Schritte gemäß dem erfinderischen Verfahren durchzuführen, wenn das Programm auf einem Computer ausgeführt wird, sind insbesondere geeignet zur Durchführung des erfindungsgemäßen Verfahrens oder einer seiner nachfolgend erläuterten Weiterbildungen.

Bevorzugte Weiterbildungen der Erfindung ergeben sich aus den abhängigen Ansprüchen.

Die im weiteren beschriebenen Weiterbildungen beziehen sich sowohl auf die Verfahren als auch auf die Anordnung.

Die Erfindung und die im weiteren beschriebenen Weiterbildungen können sowohl in Software als auch in Hardware, beispielsweise unter Verwendung einer speziellen elektrischen Schaltung, realisiert werden.

Ferner ist eine Realisierung der Erfindung oder einer im weiteren beschriebenen Weiterbildung möglich durch ein computerlesbares Speichermedium, auf welchem das Computerprogramm mit Programmcode-Mitteln gespeichert ist, welches die Erfindung oder Weiterbildung ausführt.

Auch kann die Erfindung oder jede im weiteren beschriebene Weiterbildung durch ein Computerprogrammerzeugnis realisiert sein, welches ein Speichermedium aufweist, auf welchem das Computerprogramm mit Programmcode-Mitteln gespeichert ist, welches die Erfindung oder die Weiterbildung ausführt.

Zur Bildung der topologischen Graphenstruktur können Shock-Graphen [1] oder eine "medial axis" [1], [8] oder auch Voronoi-Graphen [8], [9], [10] bzw. entsprechende Verfahren zur Bildung der beispielhaft genannten Graphenarten herangezogen werden. Die erzeugten Graphen weisen dabei in der Regel eine Abfolge von Knoten und Kanten auf.

Die Abstandsinformation ist so zu wählen, dass unter Verwendung der mit der Abstandsinformation angereicherten Graphenstruktur die Hindernisse der Fläche, welche meist mit einer Begrenzung der Freifläche zumindest zum Teil übereinstimmen, ermittelbar oder rekonstruierbar sind. Zweckmäßig ist es beispielsweise, wenn die Abstandsinformation eine Größe und/oder Form der Freifläche beschreibt, beispielsweise durch Angabe von Entfernungen zwischen Elementen, d.h. Knoten oder Kanten, der topologischen Graphenstruktur und den Hindernissen oder den Begrenzungen der Freiflächen.

Die Entfernungen bzw. eine entsprechende Entfernungsinformation kann durch sensorbasierte Abstandsmessungen, wie Laser-, Ultraschallmessungen oder Messungen durch Video-Systeme, ermittelt werden.

Auch kann die Abstandsinformation gebildet werden unter Verwendung von Kreisradien von Kreisen, deren Kreismittelpunkte zumindest teilweise die topologische Graphenstruktur bilden. Dies ist besonders dann zweckmäßig, wenn die topologische Graphenstruktur unter Verwendung von Shock-Graphen [1], "medial axis" [1], [8] oder Voronoi-Graphen [8], [9], [10] bzw. entsprechende Verfahren gebildet wird.

Die Annotierung, d.h. die Anreicherung, der topologischen Graphenstruktur mit der Abstandsinformation lässt sich einfach durchführen, wenn die Abstandsinformation numerisch-codiert oder farb-codiert der topologischen Graphenstruktur zugeordnet wird.

So können beispielsweise einfache numerische Entfernungsangaben den Elementen, nämlich den Knoten und Kanten, der topologischen Graphenstruktur zugeordnet werden.

Dabei ist darauf zu achten, dass sowohl Kanten als auch Knoten die Abstandsinformation zugeordnet wird, da in der Regel nur dann gewährleistet ist, dass die Hindernisse der Fläche rekonstruierbar sind. Die bloße Zuordnung zu den Knoten der topologischen Graphenstruktur reicht in der Regel für die Rekonstruktion nicht aus.

Ein Beschreibungsgehalt der Graphenstruktur kann weiter erhöht werden, wenn die topologische Graphenstruktur mit weiterer Information, insbesondere einer Krümmungsinformation, angereichert bzw. annotiert wird. Durch eine solche Krümmungsinformation kann beispielsweise ein Verlauf einer Kante der topologischen Graphenstruktur beschreiben werden. Auch kann die topologische Graphenstruktur durch optische Information, wie optische Eindrücke einer Kamera, angereichert werden.

Die topologische Graphenstruktur kann ferner unter Verwendung einer geometrischen Karte der Fläche, insbesondere einer lokalen geometrischen Gitterkarte, und/oder unter Verwendung von Entfernungsinformation generierenden Sensormessungen, insbesondere Laser-/Ultraschallmessungen oder Messungen von Videosystemen, ermittelt werden.

Die Erfindung lässt sich insbesondere zum Aufbau großer, globaler Flächenbeschreibungen, d.h. entsprechend strukturierter Karten, einsetzen.

In diesem Fall wird für mehrere Flächen einer Gesamtfläche jeweils die zugehörige Graphenstruktur ermittelt. Anschließend werden die Graphenstrukturen der Flächen zu einer Gesamtgraphenstruktur, der strukturieren Karte, zusammengefügt bzw. verschmolzen.

Weiterführend kann nun diese strukturierte Karte der Gesamtfläche bzw. die Gesamtgraphenstruktur zu einer Lokalisierung, beispielsweise einer mobilen Einheit, welche sich in einem Teil der Gesamtfläche bewegt bzw. aufhält, eingesetzt werden.

Dazu wird für diesen Teil bzw. diese Teilfläche die zugehörige Graphenstruktur erfindungsgemäß ermittelt. Anschließend wird die Graphenstruktur der Teilfläche mit der Gesamtgraphenstruktur verglichen und dabei die der Graphenstruktur der Teilfläche entsprechende Teilgraphenstruktur in der Gesamtgraphenstruktur bestimmt. Anhand der Teilgraphenstruktur bzw. deren Lage in der Gesamtgraphenstruktur kann die mobile Einheit lokalisiert werden.

Zur Durchführung des Vergleichs stehen verschiedenen Verfahren basierend auf bekannten Methoden zur Verfügung, wie beispielsweise ein hierarchischen Ausschlussverfahren und/oder ein statistisches Matching-Verfahren und/oder ein "Constraint Propagation"-Verfahrens. Eine Sicherheit beim Vergleich kann gegebenenfalls erhöht werden, wenn die genannten Verfahren miteinander kombiniert angewandt werden.

In Weiterbildungen kann die Erfindung insbesondere eingesetzt werden bei mobilen Einheiten, wie mobile Roboter. Dabei kön nen unter Verwendung der erfindungsgemäßen Vorgehensweise Aufgaben bei mobilen Einheiten, wie Lokalisierungs-, Orientierungs- und/oder Bahnplanungsaufgaben gelöst werden.

In solchen Fällen wird die mobile Einheit unter Verwendung der erfindungsgemäßen Graphenstruktur lokalisiert und/oder unter Verwendung dieser navigiert.

In Figuren ist ein Ausführungsbeispiel der Erfindung dargestellt, welches im weiteren näher erläutert wird.

Es zeigen
- Figur 1: Skizze einer lokalen geometrischen Gitterkarte;
- Figur 2: Skizze eines lokalen mit Abstandsinformation annotierten Teilgraphen einer Teilfläche bzw. einer mit Abstandsinformation annotierten medial axis einer Teilfläche;
- Figur 3: Skizze eines globalen mit Abstandsinformation annotierten Gesamtgraphen einer Gesamtfläche (farbcodiert) bzw. einer mit Abstandsinformation annotierten medial axis einer Gesamtfläche (farbcodiert);
- Figur 4: Skizze eines globalen mit Abstandsinformation annotierten Gesamtgraphen einer Gesamtfläche mit aus der Abstandsinformation rekonstruierten Hindernissen bzw. Begrenzungslinien einer Freifläche;
- Figur 5: Skizze einer von einem mobilen Roboter zu bearbeitenden Gesamtfläche mit Hindernissen (Umgebung) mit dem mobilen Roboter an einer aktuellen Position;
- Figur 6: Skizze eines lokalen mit Abstandsinformation annotierten Teilgraphen derjenigen Teilfläche, in welcher sich der mobile Roboter aus Figur 5 aktuell aufhält;
- Figur 7: Skizze eines globalen mit Abstandsinformation annotierten Gesamtgraphen der Gesamtfläche aus Figur 5, mit farbcodierten Positionswahrscheinlichkeiten des mobilen Roboters an Knoten des Gesamtgraphen (Lokalisierung);
- Figur 8: Skizze von Verfahrensschritten bei der Lokalisierung eines mobilen Roboters gemäß einem Ausführungsbeispiel.

### Ausführungsbeispiel: Lokalisierung eines mobilen Roboters in einer Gesamtfläche unter Verwendung eines mit Abstandsinformation annotierten Gesamtgraphen

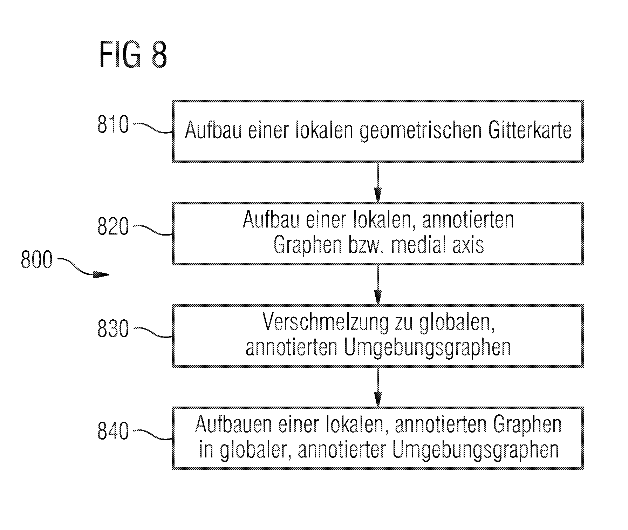

In Fig.8 sind Verfahrensschritte 810 bis 840 (Fig.8, 800) bei einer Lokalisierung eines autonomen, mobilen Roboters in einer Gesamtfläche unter Verwendung eines mit Abstandsinformation annotierten Gesamtgraphen bzw. einer mit Abstandsinformation annotierter "medial axis" dargestellt.

Der mobile Roboter, im Ausführungsfall ein Reinigungsroboter, ist ausgestattet unter anderem mit einer Reinigungsvorrichtung, mehreren Laserscannern, Sensoren zur Messung von Abständen und Entfernungen sowie einer Rechen- bzw. Auswerteeinheit.

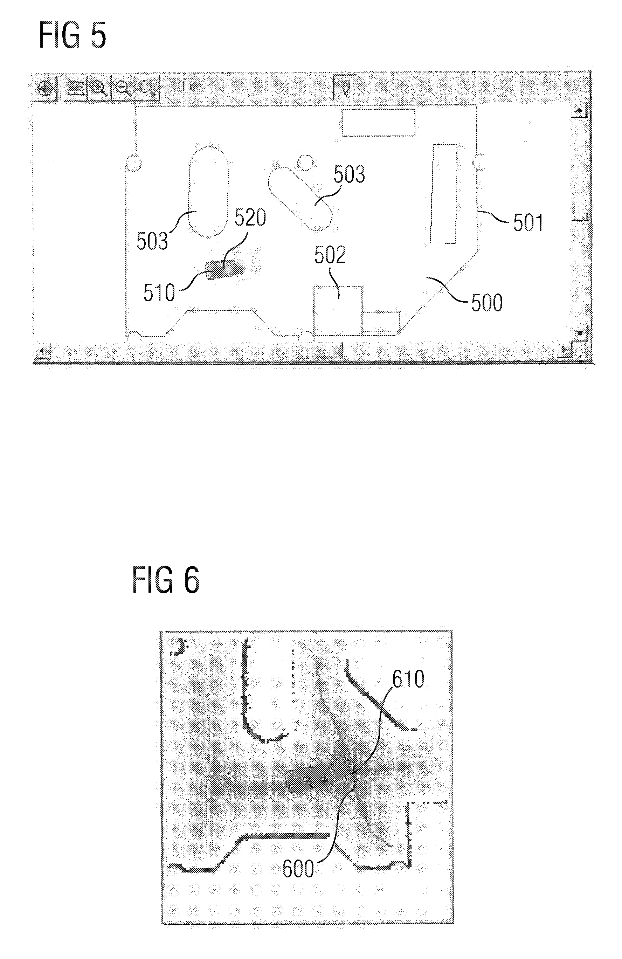

Die Gesamtfläche 500 (vgl. Fig.5), im Ausführungsfall eine zu reinigende Fläche, wird allseitig begrenzt durch Wände 501 und an den Wänden 501 aufgestellten Hindernisse 502, wie Schränke und Regale. Auch sind in der Gesamtfläche 500 weitere verschiedene Hindernisse 503 aufgestellt, welche bei der Reinigung durch den mobilen Roboter zu beachten sind.

Für einen autonomen Betrieb des Roboters nehmen dessen Laserscanner ständig Bilder einer Umgebung des Roboters auf und führen die aufgenommenen Bilder der Recheneinheit des Roboters zu. Dort erfolgt eine Speicherung und eine weitere Auswertung der Bilder.

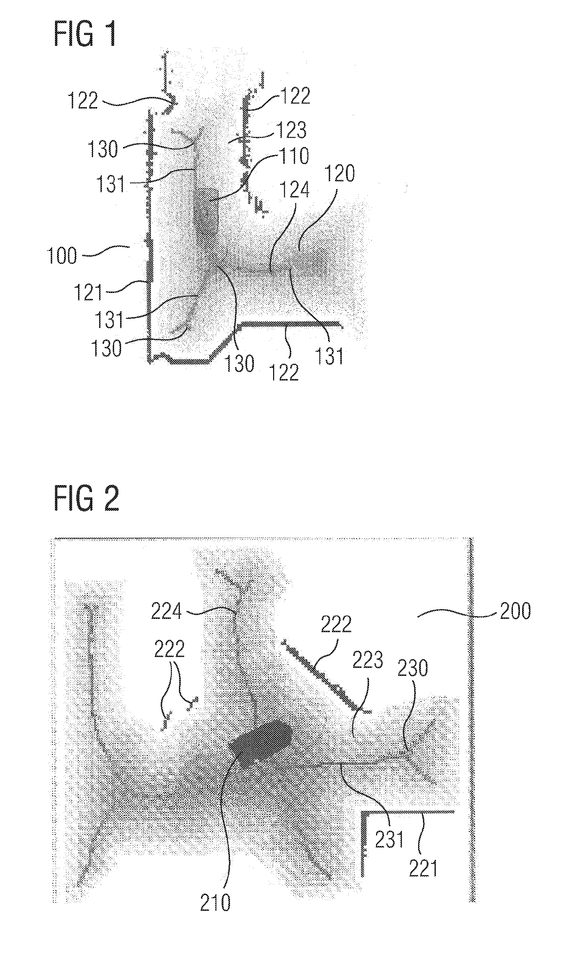

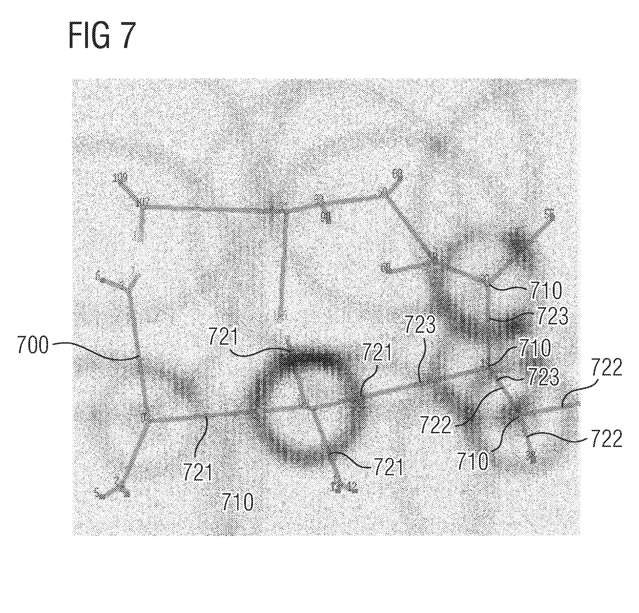

Die weitere Auswertung der Bilder umfasst auch das nachfolgend beschriebene Lokalisierungsverfahren 800 gemäß Fig.8 mit den Verfahrensschritten 810 bis 840 zusammen mit den Figuren 1 bis 7.

Fig. 8 zeigt:
Verfahrensschritt 1): Ständiger Aufbau einer lokalen geometrischen Gitterkarte einer Umgebung (810; Fig.1),
Verfahrensschritt 2): Aufbau eines lokalen, um Abstandsinformation angereicherten Graphen (lokale, annotierte medial a-xis),
Verfahrensschritt 3); Verschmelzung lokaler annotierter Graphen in eine globale, annotierte Graphenstruktur,
Verfahrensschritt 4) Auffinden eines lokalen, annotierten Graphen in der globalen, annotierten Graphenstruktur.

### Verfahrensschritt 1): Ständiger Aufbau einer lokalen geometrischen Gitterkarte einer Umgebung (810; Fig.1)

Fig.1 zeigt eine lokale geometrische Gitterkarte 100 der lokalen, d.h. näheren, Umgebung des mobilen Roboters 110 und somit einen lokalen Ausschnitt aus der Gesamtfläche. Eine solche lokale geometrische Gitterkarte 100 wird ständig während einer Fahrt des mobilen Roboters 110 erstellt bzw. aufgebaut und gespeichert.

Dazu "scannt" der mobile Roboter 100 während seiner Fahrt mittels seiner Laserscanner ständig die Umgebung, erzeugt dadurch Umgebungsbilder und erstellt daraus die lokalen, geometrischen Gitterkarten.

Bewegtobjekte, wie Personen, werden gegebenenfalls erkannt und herausgefiltert.

Gleichzeitig werden mittels der Sensoren Abstände und Entfernungen zu den Wänden 121 und Hindernissen 122 ermittelt und diese in die lokalen geometrischen Gitterkarten 100 integriert.

Entsprechende Verfahren zur Erstellung bzw. zum Aufbau solcher lokalen, geometrischen Gitterkarten sind in [11], [12], [13] beschrieben.

Die in Fig.1 dargestellte lokale geometrische Gitterkarte 100 zeigt in diesem Fall einen Gang 120, der begrenzt wird durch die Wände 121 und die Hindernisse 122. Nicht von Hindernissen versperrte Flächen werden auch als Freiflächen bezeichnet.

### Verfahrensschritt 2): Aufbau eines lokalen, um Abstandsinformation angereicherten Graphen (lokale, annotierte medial a-xis, Fig.1 und Fig.2)

Ausgehend von einer solchen lokalen geometrischen Gitterkarte 100, 200 sowie unter Verwendung der entsprechenden Abstandsinformation zu den Wänden 121, 221 und den Hindernissen 122, 222 wird eine mit der Abstandsinformation annotierte "medial axis" 124, 214 in der Freifläche 123, 223 bestimmt.

Zuerst wird dabei eine nicht annotierte "medial axis" ermittelt. Entsprechende Verfahren zur Ermittlung einer nicht annotierten "medial axis" sind in [1], [8] beschrieben. Die erzeugte, nicht annotierte "medial axis" weist dabei eine Abfolge von Knoten 130, 230 und Kanten 131, 231 auf.

Diesen, d.h. sowohl den Kanten 131, 231 als auch den Knoten 130, 231, wird anschließend die jeweilige zugehörige Abstandsinformation zugewiesen (annotiert).

Die Zuweisung erfolgt derart, dass jedem Knoten 130, 230 und jeder Kante 131, 231 die Entfernung bzw. der Abstand zum nächst entferntesten Objekt, d.h. zum nächst entferntesten Hindernis 122, 222 bzw. zur nächst entferntesten Wand 121, 221 zugeordnet wird. Dadurch wird die zunächst nicht annotierte "medial axis" annotiert und damit um die Anstandsinformation angereichert.

Zugeordnet werden numerische Abstandswerte bzw. Entfernungen, wobei zur Veranschaulichung der annotierten "medial axis" diese entsprechend der jeweiligen zugeordneten Abstandswerte in der lokalen geometrischen Gitterkarte 100, 200 farbcodiert dargestellt wird.

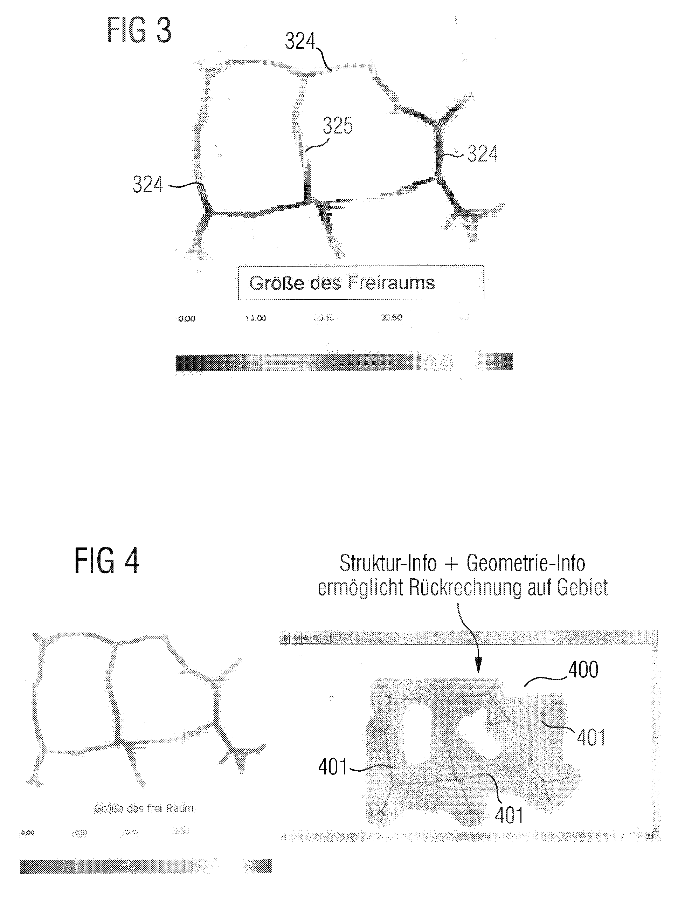

### Verfahrensschritt 3): Verschmelzung lokaler annotierter Graphen in eine globale, annotierte Graphenstruktur (Fig.3 und Fig.4)

Während einer Fahrt des mobilen Roboters 110, 210 werden nun die ermittelten lokalen annotieren Graphen bzw. "medial axis" 224, 324 zu einem globalen annotierten Umgebungsgraphen 325, 400 (globale annotierte Graphenstruktur) fusioniert bzw. verschmolzen.

Dazu werden neue Teile eines lokalen, annotierten Graphen 324, 401 an den globalen, annotierten Umgebungsgraphen 325, 400 angefügt und/oder Teile des globalen, annotierten Umgebungsgraphen 325, 400 durch Teile eines lokalen, annotierten Graphen 324, 401 ersetzt.

Zur Anfügung neuer Graphenteile bzw. zur Ersetzung von Graphenteilen ist jeweils zu entscheiden, welche Graphenteile neu sind. Dies erfolgt durch sogenanntes "Matching" zweier lokaler, annotierter Graphen und/oder "Matching" eines lokalen, annotierten Graphen mit dem globalen, annotierten Umgebungsgraphen jeweils unter Berücksichtigung der Bewegung des mobilen Roboters.

Ausgegangen wird zu Beginn der Verschmelzung von einem schon zum Teil bestehenden und gespeicherten globalen, annotierten Umgebungsgraphen oder - falls ein solcher noch nicht existiert - von einem lokalen, annotierten Graphen, welcher zu dem globalen, annotierten Umgebungsgraphen aus- bzw. aufgebaut wird.

Am Ende der Verschmelzung steht ein vollständig aufgebauter globaler, annotierter Umgebungsgraphen der Gesamtfläche.

### Verfahrensschritt 4): Auffinden eines lokalen, annotierten Graphen oder eines Graphenteils desselben in der globalen, annotierten Graphenstruktur

Fig.5 zeigt den mobilen Roboter 510 an einer für ihn nicht bekannten Position 520 in der Gesamtfläche 500.

An dieser nicht bekannten Position 520 erstellt der mobile Roboter 510 nach bekannter und oben beschriebener Vorgehensweise den entsprechenden lokalen, annotierten Graphen 600 (Fig.6) .

Aufgabe bei der Positionsbestimmung ist nun, den lokalen, annotierten Graphen 600 oder eines Graphenteils desselben in der globalen, annotierten Graphenstruktur 800 (Fig.8) wiederzufinden.

Dazu wird ein hierarchisches, stufenweises Ausschlussverfahren auf Basis eines Matching-Verfahrens verwendet.

In einem ersten Schritt des Ausschlussverfahren wird ein Knoten 610 in dem lokalen, annotierten Graphen 600 gewählt. Wegen der Annotierung kann für den gewählten Knoten 610 dem lokalen, annotierten Graphen 600 zusätzlich der minimale Hindernisabstand zu diesem Knoten 610 entnommen werden.

In einem zweiten Schritt und einer ersten Matching-Stufe werden in dem globalen, annotierten Umgebungsgraphen 700 zunächst Knoten 710 mit vergleichbarem minimalen Hindernisabstand herausgesucht und diese entsprechend ihrem minimalen Hindernisabstand sortiert.

In einem dritten Schritt und einer zweiten, genaueren Matching-Stufe werden die herausgesuchten Knoten 710 entsprechend ihrer Sortierung mit dem zu lokalisierenden Knoten 610 verglichen, wobei weitere geometrische Informationen beim Vergleich berücksichtigt werden.

Diese sind die Länge, die Krümmung und die Abstandsinformation (Abstandssignatur) der an den ausgewählten Knoten 710 angrenzenden Kanten 720 bzw. 721 bzw. 722 bzw. des ausgewählten Knotens 610.

Schließlich wird in einem vierten Schritt über eine "Constraint-Propagation" oder "Relaxation" eine Zuordnung ausgewählt, für die nicht nur die einzelnen Knoten passen, sondern auch deren relative Struktur.

Auf diese Weise wird der ausgewählte Knoten 610 - und damit der lokale, annotierte Graph 600 sowie auch der mobile Roboter - in dem globalen, annotierten Umgebungsgraphen 700 lokalisiert und damit die nicht bekannte Position 520 des Roboters bestimmt.

In diesem Dokument sind folgende Schriften zitiert:
[1] Philip N. Klein et al., "Shape matching using editdistance: an implementation", Twelfth Annual ACM-SIAM Symposium on Discrete Algorithms, SODA 2001, Dept. of Computer Science, Brown Universitiy, Providence.
[2] C. Hofner and G. Schmidt, "Path Planning And Guidance Techniques For An Autonomous Mobile Cleaning Robot", International Conference on Intelligent Robots and Systems (IROS), pp. 610-617, 1994.
[3] R. Neumann de Carvalho, H.A. Vidal, P. Vieira, and M.I. Ribeiro, "Complete Coverage Path Planning and Guidance for Cleaning Robots", IEEE International Symposium on Industrial Electronics, pp. 677-682, 1997.
[4] H. Choset and P. Pignon, "Coverage Path Planning: The Boustrophedon Cellular Decomposition", International Conference on Field and Service Robotics, 1997.
[5] A. Zelinsky, R. A. Jarvis, J. C. Byarne and S. Yuta, "Planning Paths of Complete Coverage of an Unstructered Environment by a Mobile Robot", International Conference on Robotica and Automation (ICRA), pp. 533-538, 1993.
[6] E. Prassler, D. Schwammkrug, B. Rohrmoser, and G. Schmidl, "Autonomous Road Sweeping of Large Public Areas", Robotik 2000, VDI Berichte 1552, VDI Verlag GmbH, Düsseldorf, 2000.
[7] E. Prassler, D. Schwammkrug, B. Rohrmoser, and G. Schmidl, "A Robotic Road Sweeper", International Conference on Robotica and Automation (ICRA), pp. 2364-2369, 2000.
[8] Howie Choset et al., "Topological Simultaneous Localization and Mapping (SLAM): Toward Exact Localization Without Explicit Localization", S. 125-137, IEEE Transactions on Robotics and Automation, Vol. 17, No. 2, April 2001.
[9] D. Van Zwynsvoorde et al., "Incremental Topological Modeling using Local Voronoi-like Graphs", Paper Submitted to IEEE Int. Conf. On Intelligent Robots and Systems, 2000.
[10] D. Van Zwynsvoorde et al., "Building topological models for navigation in large scale environments", LAAS-CNRS, Toulouse, France, 2001.
[11] Sebastian Thrun, "Robotic Mapping: a Survey", Februar 2002 CMU-CS-02-11, in G. Lakemeyer, B. Nebel (eds.), "Exploring AI in the New Millenium", Kapitel 1, Morgan Kaufmann, San Francisco und erhältlich unter: http://www2.cs.cmu.edu/afs/cs.cmu.edu/user/thrun/public_h tml/papers/thrun.mapping-tr.html
[12] A. Elfes, "Occupancy Grids: A Probabilistic Framework for Robot Perception and Navigation", Department of Electrical and Computer Engineering, Carnegie Mellon Unviversity 1989
[13] H.P Moravec, "Sensor Fusion in certainty grids for mobile robots", AI Magazine, 9(2):61-74,1988

## Patentansprüche

1. Verfahren zur Ermittlung einer Graphenstruktur zur Beschreibung einer Fläche mit einer Freifläche und Hindernissen,
- bei dem eine topologische Graphenstruktur für die Freifläche der Fläche ermittelt wird,
**dadurch gekennzeichnet, dass**
- die topologische Graphenstruktur mit Abstandsinformation angereichert und dabei die Graphenstruktur gebildet wird,
- wobei unter Verwendung der mit der Abstandsinformation angereicherten Graphenstruktur die Hindernisse der Fläche ermittelbar sind.

2. Verfahren nach Anspruch 1,
bei dem die topologische Graphenstruktur unter Verwendung eines Shock-Graphen, einer "medial axis" oder eines Voronoi-Graphen gebildet wird.

3. Verfahren nach einem der vorangehenden Ansprüche,
bei dem die Abstandsinformation eine Größe und/oder Form der Freifläche beschreibt.

4. Verfahren nach einem der vorangehenden Ansprüche,
bei dem die Abstandsinformation gebildet wird unter Verwendung von Kreisradien von Kreisen, deren Kreismittelpunkte zumindest teilweise die topologische Graphenstruktur bilden.

5. Verfahren nach einem der vorangehenden Ansprüche,
bei dem die Abstandsinformation numerisch-codiert oder farbcodiert der topologischen Graphenstruktur zugeordnet wird.

6. Verfahren nach einem der vorangehenden Ansprüche,
bei dem die topologische Graphenstruktur Knoten und Kanten umfasst und die Abstandsinformation sowohl den Knoten als auch den Kanten zugeordnet wird.

7. Verfahren nach einem der vorangehenden Ansprüche,
bei dem die topologische Graphenstruktur mit weiterer Information, insbesondere einer Krümmungsinformation, welche Krümmungsinformation einen Verlauf einer Kante der topologischen Graphenstruktur beschreibt, oder einer optischen Information angereichert wird.

8. Verfahren nach einem der vorangehenden Ansprüche,
bei dem die topologische Graphenstruktur unter Verwendung einer geometrischen Karte der Fläche, insbesondere einer lokalen geometrischen Gitterkarte, und/oder unter Verwendung von Entfernungsinformation generierenden Sensormessungen, insbesondere Lasermessungen oder Messungen von Videosystemen, ermittelt wird.

9. Verfahren nach einem der vorangehenden Ansprüche,
einsetzt zur Beschreibung einer Gesamtfläche aus mehreren Flächen durch eine Gesamtgraphenstruktur,
- bei dem für die mehreren Flächen jeweils die Graphenstruktur ermittelt wird,
- bei dem die Graphenstrukturen zu der Gesamtgraphenstruktur zusammengefügt werden.

10. Verfahren nach Anspruch 9,
- bei dem für eine Teilfläche der Gesamtfläche die Graphenstruktur ermittelt wird,
- bei dem die Graphenstruktur der Teilfläche mit der Gesamtgraphenstruktur verglichen wird, wobei die Graphenstruktur der Teilfläche einer Teilgraphenstruktur in der Gesamtgraphenstruktur zugeordnet wird.

11. Verfahren nach Anspruch 10,
- bei dem der Vergleich unter Verwendung eines hierarchischen Ausschlussverfahrens und/oder eines statistischen Matching-Verfahrens und/oder eines "Constraint Propagation"-Verfahrens durchgeführt wird.

12. Verfahren nach einem der vorangehenden Ansprüche,
eingesetzt zu einer Lokalisierung und/oder Navigation einer mobilen Einheit,
bei dem die mobile Einheit unter Verwendung der Graphenstruktur lokalisiert wird und/oder bei dem die mobile Einheit unter Verwendung der Graphenstruktur navigiert wird.

13. Anordnung zur Ermittlung einer Graphenstruktur zur Beschreibung einer Fläche mit einer Freifläche und Hindernissen
- mit einer Kartiereinheit, mit der eine topologische Graphenstruktur für die Freifläche der Fläche ermittelbar ist,
**dadurch gekennzeichnet, dass**
- die Anordnung eine Annotiereinheit aufweist, mit der die topologische Graphenstruktur mit Abstandsinformation anreicherbar und dabei die Graphenstruktur bildbar ist,
- wobei unter Verwendung der mit der Abstandsinformation angereicherten Graphenstruktur die Hindernisse der Fläche ermittelbar sind.

14. Computerprogramm-Erzeugnis, das ein computerlesbares Speichermedium umfasst, auf dem ein Programm gespeichert ist, das es einem Computer ermöglicht, nachdem es in einen Speicher des Computers geladen worden ist, folgende Schritte durchzuführen zur Ermittlung einer Graphenstruktur zur Beschreibung einer Fläche mit einer Freifläche und Hindernissen
- eine topologische Graphenstruktur wird für die Freifläche der Fläche ermittelt,
**dadurch gekennzeichnet, dass**
- die topologische Graphenstruktur mit Abstandsinformation angereichert und dabei die Graphenstruktur gebildet wird,
- wobei unter Verwendung der mit der Abstandsinformation angereicherten Graphenstruktur die Hindernisse der Fläche ermittelbar sind.

15. Computerlesbares Speichermedium, auf dem ein Programm gespeichert ist, das es einem Computer ermöglicht, nachdem es in einen Speicher des Computers geladen worden ist, folgende Schritte durchzuführen zur Ermittlung einer Graphenstruktur zur Beschreibung einer Fläche mit einer Freifläche und Hindernissen
- eine topologische Graphenstruktur wird für die Freifläche der Fläche ermittelt wird,
**dadurch gekennzeichnet, dass**
- die topologische Graphenstruktur mit Abstandsinformation angereichert und dabei die Graphenstruktur gebildet wird,
- wobei unter Verwendung der mit der Abstandsinformation angereicherten Graphenstruktur die Hindernisse der Fläche ermittelbar sind.

16. Computerprogramm mit Programmcode-Mitteln, um alle Schritte gemäß Anspruch 1 durchzuführen, wenn das Programm auf einem Computer ausgeführt wird.

17. Computerprogramm mit Programmcode-Mitteln gemäß Anspruch 16, die auf einem computerlesbaren Datenträger gespeichert sind.

18. Computerprogramm-Produkt mit auf einem maschinenlesbaren Träger gespeicherten Programmcode-Mitteln, um alle Schritte gemäß Anspruch 1 durchzuführen, wenn das Programm auf einem Computer ausgeführt wird.
